# EUROPÄISCHE PATENTSCHRIFT

(11) **EP 1 170 782 B1**
(45) Veröffentlichungstag und Bekanntmachung des Hinweises auf die Patenterteilung: **25.04.2007**
(21) Anmeldenummer: 01114182.7
(22) Anmeldetag: 12.06.2001
(51) Int. Cl.: H01L 21/00, H01L 21/68

(54) **Vorrichtung zum Behandeln eines scheibenförmigen Gegenstandes**
Device for handling a disk-like workpiece
Dispositif pour manipuler un objet en forme de disque

(30) Priorität: 07.07.2000 DE 10033172
(43) Veröffentlichungstag der Anmeldung: 09.01.2002
(73) Patentinhaber: SEZ AG, 9500 Villach (AT)
(72) Erfinder: Lindner, Johannes, 9702 Ferndorf (AT)

(56) Entgegenhaltungen:
- EP-A- 0 976 460
- US-A- 5 591 262
- US-A- 5 879 576

## Beschreibung

Die Erfindung betrifft eine Vorrichtung zum Behandeln mindestens einer Unterseite eines scheibenförmigen Gegenstandes.

Unter scheibenförmigen Gegenständen werden Halbleitersubstrate wie Siliziumwafer, Galliumarsenidwafer, aber auch Glas- und Quarzscheiben, Metallscheiben, Flachbildschirme sowie sogenannte Harddiscs und Compactdiscs (CDs) verstanden.

Das Behandeln der Oberflächen des scheibenförmigen Gegenstandes kann beispielsweise dem Ätzen, Reinigen, Auftrag von Schichten (z. B. Electroplating) oder dem Entwickeln von Fotolack dienen.

Dabei können auf einer oder beiden Oberflächen des scheibenförmigen Gegenstandes (gleiche oder unterschiedliche) Flüssigkeiten aufgebracht werden. Wird auf beide Oberflächen die gleiche Flüssigkeit aufgebracht, so kann diese gesammelt und zurückgeführt werden. Die Verwendung von zwei verschiedenen Flüssigkeiten kann notwendig sein, wenn z. B. eine Oberfläche (eine Vorderseite) geätzt und die andere Oberfläche (eine Rückseite) gleichzeitig gegen Ätzen geschützt werden soll.

Die US 5,375,291 A beschreibt eine Vorrichtung zum gleichzeitigen Behandeln beider Oberflächen eines scheibenförmigen Gegenstandes mit Flüssigkeit. Die Vorrichtung besteht aus einem rotierbaren Träger zum Halten des scheibenförmigen Gegenstandes und umfaßt Mittel zum Aufbringen einer Flüssigkeit auf beide Seiten des Gegenstandes. Der Träger wird über eine rotierbare Hohlwelle angetrieben. Innerhalb der rotierbaren Hohlwelle befindet sich eine stehende Hohlwelle. Durch die stehende Hohlwelle wird die Behandlungsflüssigkeit zugeführt. Die rotierende Hohlwelle bildet die Welle eines sogenannten Hohlwellenmotors.

Nachteilig ist, daß durch einen offenen Spalt zwischen der stehenden und rotierenden Hohlwelle, Flüssigkeit und Feststoffteilchen, beispielsweise durch Lagerabrieb, eindringen können. Damit besteht auch die Gefahr, daß der scheibenförmige Gegenstand verunreinigt wird.

Gemäß der JP 09-314023 A wird dieses Problem dadurch gelöst, indem oberhalb des Spaltes eine Abdeckung angeordnet wird. Zusätzlich wird eine Labyrinth-Dichtung zwischen dem rotierenden Teil des Trägers und der Abdeckung angeordnet. Auch dann sind die Prozeßergebnisse jedoch unbefriedigend. Die dem Träger zugewandte Oberfläche des scheibenförmigen Gegenstandes wird, wenn zuvor bereits mehrere Wafer behandelt wurden, verunreinigt. Untersuchungen haben gezeigt, daß sich auf der Abdeckung auch Flüssigkeitströpfchen ablagem.

Aufgabe der Erfindung ist es demnach, eine Vorrichtung der genannten Art anzubieten, mit der sich Verunreinigungen am scheibenförmigen Gegenstand verringern bis vermeiden lassen, und zwar sowohl Verunreinigungen, die durch Partikel aus der Mechanik entstehen, als auch solche durch abgelagerte Flüssigkeitströpfchen.

### Dabei liegt der Erfindung folgender Gedanke zugrunde:

Wird unmittelbar unterhalb des zu behandelnden scheibenförmigen Gegenstandes (nachstehend Wafer genannt) eine statische Einrichtung (Abdeckung) angeordnet, beispielsweise um die Zuführleitung für ein Behandlungsmedium herum, kommt es in dem Raum unterhalb des Wafers zu Verwirbelungen, die die genannten Probleme verursachen. Die Erfindung geht deshalb einen anderen Weg: Zwischen dem rotierbaren Träger, der der Aufnahme des Wafers dient, und dem Wafer werden keine weiteren Bauteile angeordnet. Dabei nimmt die Erfindung in Kauf, daß zwischen der (statischen) Zuführleitung für das Behandlungsmedium und dem rotierenden Träger zwangsläufig ein Spalt besteht, in den Flüssigkeitströpfchen oder Staubteilchen eindringen können. Deren Beseitigung dient erfindungsgemäß ein unterhalb des Trägers angeordneter statischer Bauteil der Vorrichtung, nachstehend Abdeckung genannt, wobei zwischen dem genannten Spalt im Bereich der oberen Stimfläche des Trägers in dessen Verlängerung ein weiterer Spalt zwischen einer Unterseite des Trägers und der Oberseite der statischen Abdeckung vorgesehen wird, über den die genannten Flüssigkeitströpfchen und Feststoffteilchen weggeführt werden können. Dabei kommt es aufgrund der Rotationsbewegung des Trägers gegenüber der statischen Abdeckung in diesem Spaltbereich zu Verwirbelungen und Zentrifugalkräften auf die Fremdteilchen, die so sicher nach außen (radial zu der genannten Zuführleitung für das Behandlungsmedium) weggeführt werden.

In ihrer allgemeinsten Ausführungsform betrifft die Erfindung danach eine Vorrichtung zum Behandeln mindestens einer Unterseite eines scheibenförmigen Gegenstandes mit folgenden Merkmalen:
- Einem rotierbaren Träger mit einer oberen Stirnfläche, von der, zur Positionierung des scheibenförmigen Gegenstandes, parallel zur oberen Stirnfläche des Trägers, mindestens zwei Einrichtungen abstehen,
- mindestens einer, ortsfest angeordneten, mittig den Träger durchgreifenden Leitung zur Zuführung eines Behandlungsmediums gegen die Unterseite des scheibenförmigen Gegenstandes,
- einer, unter Ausbildung eines Ringspalts, im Abstand zu mindestens einem Abschnitt einer unteren Stirnfläche des Trägers ortsfest angeordneten Abdeckung, die von der mindestens einen Leitung spielfrei durchgriffen wird.

Gemäß dem ersten Teilmerkmal ist der rotierende Träger mit mindestens zwei Einrichtungen zur Positionierung des Wafers gestaltet. Üblicherweise sind mindestens drei solcher Einrichtungen vorgesehen, beispielsweise im Winkelabstand von 120 Grad zueinander. Solche Einrichtungen, auch "Pins" genannt, können radial verstellbar angeordnet sein, um den Wafer zu führen/greifen. Die nachfolgende Figurenbeschreibung gibt weitere Hinweise.

Gemäß dem zweiten Teilmerkmal verläuft mindestens eine Behandlungsleitung durch die Vorrichtung, und zwar vorzugsweise in oder parallel zur Mittenlängsachse der Vorrichtung und damit senkrecht zur Ausrichtung des Wafers. Durch diese Leitung(en) kann/können Flüssigkeiten oder Gase zur Behandlung des Wafers geführt werden. Darüber hinaus kann eine Leitung auch als Lichtleiter ausgebildet sein, der beispielsweise zur Detektierung reflektierten Lichtes von der Unterseite des Wafers dient und so einen Zustand anzeigen kann, bei dem die Behandlung abgeschlossen ist. Der Lichtleiter kann auch anzeigen, ob überhaupt ein Wafer aufliegt.

Das dritte Teilmerkmal sieht eine ortsfest angeordnete Abdeckung unterhalb und mit Abstand zum Träger vor. Diese statische Abdeckung ist spielfrei (nahtlos) mit der oder den statischen Leitung(en) verbunden. Damit ergibt sich ein durchgehender Kanal (Spalt), der sich von der Stirnfläche des Trägers, benachbart zu der/den Leitung(en) in den Spalt zwischen Abdeckung und Träger erstreckt. Wie nachstehend noch näher beschrieben wird, soll dieser Spalt radial nach außen offen weitergeführt werden.

Aufgabe und Funktionsweise des Spaltes wurden vorstehend bereits beschrieben.

Nach einer Ausführungsform kann die Abdeckung, benachbart zu der mindestens einen Leitung, einen parallel zur oberen Stirnfläche des Trägers verlaufenden inneren Teil und einen randseitigen, von der oberen Stirnfläche des Trägers abfallenden äußeren Teil aufweisen. Hierdurch wird die radiale Wegführung von Fremdteilchen oder Flüssigkeitspartikeln erleichtert.

Um eine konstante Spalthöhe zu erreichen, kann die untere Stirnfläche des Trägers korrespondierend zur Abdeckung gestaltet sein. Nach einer weiteren Ausführungsform überragt der Träger die Abdeckung außenseitig und damit radial zu der/den Leitung(en). Diese Ausführungsform ist ebenfalls in der nachfolgenden Figurenbeschreibung dargestellt Die Abdeckung kann auf einem, die mindestens eine Leitung aufnehmenden rohrförmigen Körper ortsfest aufsitzen. Der rohrförmige Körper kann in Richtung von der oberen Stimfläche des Trägers weg durch die Vorrichtung hindurch bis zu einem statischen Boden geführt werden.

Nach einer weiteren Ausführungsform schließt sich an die untere Stirnfläche des Trägers randseitig eine Ringscheibe an, die die Leitung(en) mit Abstand umgreift und außenseitig mit dem Träger verbunden werden kann sowie im übrigen im Abstand zur Abdeckung verläuft. Zwischen dem Träger und der Ringscheibe kann, in Verlängerung des Ringspalts, mindestens ein im Wesentlichen radial zu der mindestens einen Leitung verlaufender Spalt angeordnet werden. Dieser schafft die Verlängerung der zuvor genannten Spaltbereiche zwischen Träger und Leitung bzw. Träger und Abdeckung nach außen, um Flüssigkeitströpfchen oder feste Teilchen wegzuführen, die aufgrund der Rotationsbewegung des Trägers bzw. der Scheibe gegenüber der Abdeckung unter Einwirkung von Zentrifugalkräften nach außen geführt werden.

Vorzugsweise sind eine Vielzahl von Spaltabschnitten zwischen dem äußeren Abschnitt des Trägers und dem äußeren Abschnitt der Ringscheibe vorgesehen, wobei die einzelnen Abschnitte wiederum in gleichem Winkelabstand zueinander über den Umfang verteilt angeordnet sein können.

Die Ringscheibe, die sich mit dem Träger drehen soll, kann dazu innenseitig auf einem Drehlager geführt werden, welches sich gegen den zuvor genannten, die Abdeckung tragenden rohrförmigen Körper abstützt.

Die Ringscheibe kann im Weiteren, insbesondere innenseitig, mit einer rohrförmigen Verlängerung ausgebildet sein, die parallel zu der mindestens einen Leitung in Richtung von der unteren Stirnfläche des Trägers weg verläuft und damit parallel und im Abstand zum rohrförmigen Körper. Der Abstand zwischen rohrförmiger Verlängerung und rohrförmigem Körper ist wichtig, da ein Drehteil (die rohrförmige Verlängerung) gegen einen statischen Teil (rohrförmiger Körper) positioniert werden muss.

Die rohrförmige Verlängerung an der Scheibe kann an einen Rotations-Antrieb gekuppelt werden. Beispielhaft kann dies von einem Motor geleistet werden, dessen Rotor mit der rohrförmigen Verlängerung verbunden ist und dessen Stator über mindestens ein Drehlager gegen die rohrförmige Verlängerung anliegt.

Neben der beschriebenen Behandlung der Unterseite eines Wafers kann die Vorrichtung mit einer weiteren Zuführeinrichtung für ein Behandlungsmedium oberhalb des Wafers ausgerüstet werden, um auch die Oberseite des Wafers zu behandeln. In beiden Fällen sind die entsprechenden Leitungen statisch und werden nicht durch drehende Teile gestört. Trotzdem gibt es kein Problem bei der Abdichtung der drehenden Teile gegenüber den stehenden Teilen.

Weitere Merkmale der Erfindung ergeben sich aus den Merkmalen der Unteransprüche sowie den sonstigen Anmeldungsunterlagen.

Die Erfindung wird nachstehend anhand verschiedener Ausführungsbeispiele näher beschrieben. Dabei zeigen, jeweils in schematisierter Darstellung
- Figur 1:: Eine Aufsicht auf eine erfindungsgemäße Vorrichtung.
- Figur 2:: Einen Längsschnitt durch die Vorrichtung nach Figur 1.
- Figur 3:: Eine Schnittdarstellung gemäß Figur 2 mit unterschiedlichem Antrieb gegenüber dem Ausführungsbeispiel nach Figur 2.
- Figur 4:: Einen Längsschnitt analog Figur 1 mit einer zugehörigen Auffangvorrichtung für eine Behandlungsflüssigkeit.

In den Figuren sind gleiche oder gleichwirkende Bauteile mit gleichen Bezugsziffern dargestellt.

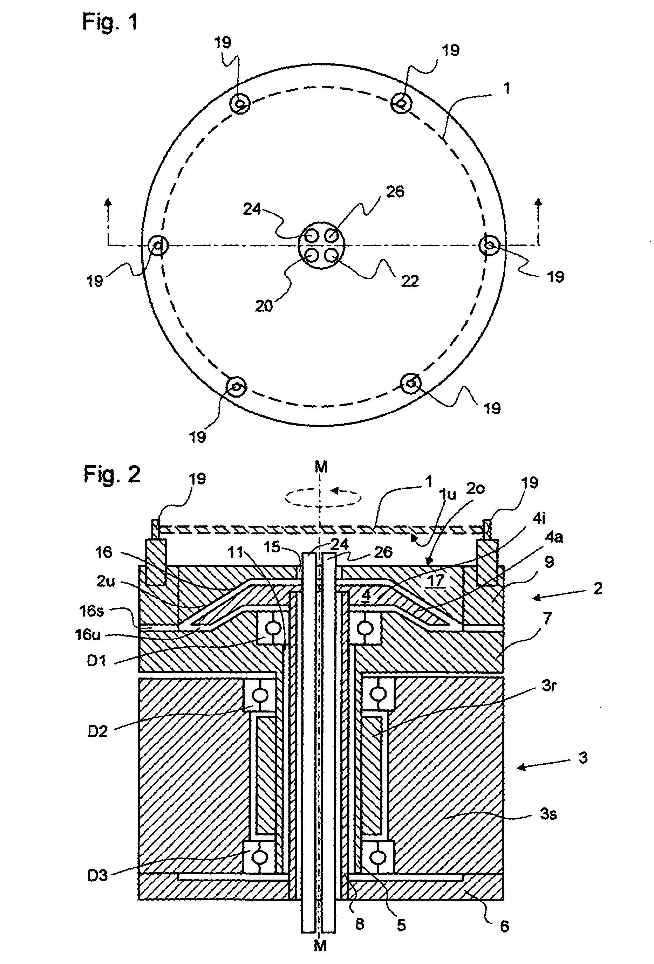

Eine in den Figuren 1,2 dargestellte Vorrichtung umfasst einen rotierbaren Träger 2, der aus einem äußeren Ring 9 und einem inneren Zwischenkörper 17 besteht, der mittig (konzentrisch zur Mittenlängsachse M der Vorrichtung) eine Öffnung 15 aufweist. Vom Ring 9 erstrecken sich sechs Greifelemente 19 (sogenannte Pins) senkrecht nach oben von einer oberen Stirnfläche 2o des Trägers 2. Die Greifelemente 19 dienen dazu, einen Wafer 1 randseitig zu greifen und in paralleler Ausrichtung zur Stirnfläche 2o des Trägers 2 zu halten.

Mit Abstand unterhalb des Zwischenkörpers 17 ist eine Abdeckung 4 angeordnet, die konzentrisch zur Mittenlängsachse M verläuft und auf einem Rohrkörper 8 aufsitzt, der sich in Figur 2 nach unten bis zu einer Bodenplatte 6 der Vorrichtung erstreckt.

Die Abdeckung 4 besitzt einen inneren Abschnitt 4i, parallel zur oberen Stirnfläche 20 des Trägers 2, und einen nach unten abfallenden äußeren Teil 4a.

Mit Abstand 16u unterhalb der Abdeckung 4 folgt eine Ringscheibe 7, die umfangsseitig mit dem Ring 9 verbunden ist, innenseitig (am oberen Ende) über einem Drehlager D1 auf dem Rohrkörper 8 aufsitzt und innenseitig (unten) eine rohrförmige Verlängerung 5 besitzt, die parallel zum Rohrkörper 8 mit Abstand um den Rohrkörper 8 nach unten in Richtung auf die Bodenplatte 6 verläuft.

Die Öffnung 15 im Zwischenkörper 17 setzt sich in einem Ringspalt 16 zwischen Abdeckung 4 und Träger 2 (Zwischenkörper 17) fort und ist radial nach außen über verschiedene rohrförmige Kanäle 16s verlängert, die zwischen der Ringscheibe 7 und dem Ring 9 ausgebildet sind.

Beim Zusammenbau der Vorrichtung wird zunächst die Scheibe 7 angeordnet, dann die Abdeckung 4 aufgesetzt und schließlich die Baueinheit aus Ring 9 und Zwischenkörper 17 zugeführt.

Mit Abstand unterhalb der Ringscheibe 7 ist ein Motor 3 angeordnet, der aus einem äußeren Statorteil 3s und einem inneren Rotorteil 3r besteht, der gegen die rohrförmige Verlängerung 5 anliegt, während der Statorteil 3s über zwei Drehlager D2, D3 am oberen und unteren Ende gegen die rohrförmige Verlängerung 5 anliegt. Der Motor (Statorteil 3s) liegt auf der Bodenplatte 6 auf. Die Bodenplatte 6 weist mittig eine Ausnehmung auf, so dass die rohrförmige Verlängerung 5 mit Abstand zur Bodenplatte 6 endet.

In dem statischen, rohrförmigen Körper 8 verlaufen vier Leitungen 20, 22, 24, 26. Die Leitungen 22, 24 dienen der Zuführung einer Behandlungsflüssigkeit, die Leitung 26 einer Gaszuführung und die Leitung 20 ist als Lichtleiter ausgebildet. Alle Leitungen erstrecken sich von einem Bereich unterhalb der Bodenplatte 6 bis in den Bereich der Öffnung 15 im Träger 2 und überragen die obere Stirnfläche 2o des Trägers 2, wie in Figur 2 dargestellt.

Die Leitungen 20, 22, 24, 26 sind spielfrei (nahtlos) durch entsprechende Öffnungen in der Abdeckung 4 geführt.

Nach Aufsetzen eines Wafers und Anschalten des Motors 3 rotieren folgende Bauteile der Vorrichtung:
Rotor 3r, Ringscheibe 7, Ring 9, Zwischenkörper 17, Greifelemente 19 und Wafer 1.

Dem gegenüber verbleiben die Abdeckung 4, der rohrförmige Körper 8 und die Bodenplatte 6 sowie der Statorteil 3s des Motors in ruhender Position.

Flüssigkeit, die über die Leitungen 22, 24 gegen eine Unterseite 1u des Wafers 1 geführt wird, wird aufgrund der Rotationsbewegung des Wafers 1 nach außen geführt. Auf diese Weise kann die Unterseite 1u des Wafers beispielsweise geätzt werden. Etwaige, nach unten abfallende Flüssigkeitspartikel können durch die Öffnung 15 in den Spalt 16 und von dort über die Spaltverlängerung 16s nach außen weggeführt werden, und zwar wiederum aufgrund von Zentrifugalkräften, die durch die rotierende Bewegung des Trägers 2 gegenüber der statischen Abdeckung 4 initiiert werden.

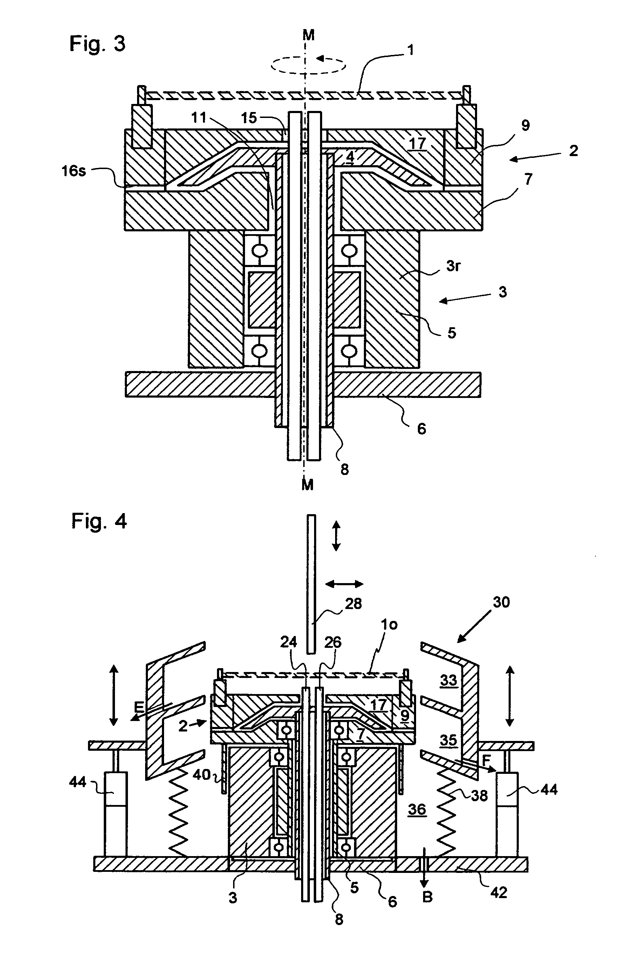

Im Gegensatz zum Ausführungsbeispiel nach Figur 2, bei dem der Motor 3 als Hohlwellenmotor mit Innenläufer gestaltet ist, wird für den Antrieb beim Ausführungsbeispiel nach Figur 3 ein Hohlwellenmotor verwendet, der als sogenannter Außenläufer gestaltet ist. Die Rotationsbewegung wird dabei über den außenliegenden Rotor 3r unmittelbar auf die Ringscheibe 7 und weiter auf den Träger 2 übertragen. Die Ringscheibe 7 ist gleichzeitig im Abstand zum statischen Rohrkörper 8 angeordnet, wodurch ein Spalt 11 zwischen beiden Bauteilen entsteht, der von der Abdeckung 4 überdeckt wird.

Das Ausführungsbeispiel nach Figur 4 ähnelt dem nach Figur 2. Zusätzlich ist umfangsseitig an der Ringscheibe 7 eine nach unten vorstehende zylinderförmige Abdeckung 40 angeschlossen, die einen Spalt zwischen der Ringscheibe 7 und der Antriebseinheit 3 (dem Motor) gegenüber einem äußeren Prozeßtopf 30 abschirmt.

Die Bodenplatte 6 ist umfangsseitig verlängert (Abschnitt 42). Vom Abschnitt 42 erstreckt sich ein Hebemechanismus 44 nach oben, der zwei hydraulische Hubzylinder umfaßt. Der Prozeßtopf 30 ist über einen zur Mittenlängsachse M konzentrisch angeordneten Faltenbalg 38, der einen ähnlichen
Durchmesser besitzt wie der Prozeßtopf 30, mit dem Abschnitt 42 verbunden. Dadurch entsteht ein innerer Bereich 36.

Der Prozeßtopf 30 besitzt zwei nach innen offene, übereinander angeordnete, ringförmige Kammern 33, 35. Durch den Hubmechanismus 44 kann der Prozeßtopf 30 auf- und abbewegt werden. Behandlungsflüssigkeit, die vom rotierenden Wafer 1 abgeschleudert wird, kann wahlweise in der Kammer 33 oder 35 gesammelt werden. Über eine Öffnung E kann Flüssigkeit aus der Kammer 33 entnommen werden. Die Kammer 35 entleert über eine bodenseitige Öffnung F.

Oberhalb des Wafers 1 ist eine Leitung 28 angeordnet, über die Flüssigkeit auf die Oberfläche 1o des Wafers aufgetragen werden kann.

Wird auf die obere und untere Oberfläche des Wafers 1 die gleiche Flüssigkeit aufgebracht, so kann diese über ein nicht dargestelltes System aufbereitet und dem Wafer wieder zugeführt werden.

Flüssigkeit, die auf die dem Träger 2 zugewandte Oberfläche des Wafers 1 aufgebracht wurde, kann teilweise (in geringem Umfang) in den offenen Bereich 15 des Zwischenkörpers 17 gelangen, wie dies auch in Figur 2 dargestellt ist. Flüssigkeitströpfchen gelangen dann auf die nicht rotierende Abdeckung 4. Während der Rotation des Trägers 2 wird ein Gaswirbel im Spalt 16 zwischen Abdeckung 4 und Träger 2 (Zwischenkörper 17) induziert. Diese Tröpfchen auf der Abdeckung 4 werden durch den Gaswirbel radial nach außen befördert und über die Spalte 16, 16s aus der Vorrichtung ausgetragen. Partikel, die z. B. durch Lagerabrieb entstanden sind und die sich im Spalt zwischen der Ringscheibe 7 und der Abdeckung 4 befinden, können auf ähnliche Weise abgeführt werden.

Tröpfchen, die auf der dem Wafer 1 zugewandten Stirnfläche 2o des Trägers 2 anfallen, werden durch die Rotation des Trägers 2 radial nach außen befördert und ebenso abgeschleudert wie die Flüssigkeit, die auf den Wafer 1 gelangt.

Der Raum 36 innerhalb des Prozeßtopfes 30 kann über eine Öffnung B im Abschnitt 42 der Grundplatte abgesaugt werden. Dadurch wird ein konstanter Gasstrom nach unten erreicht, wodurch verhindert wird, daß Partikel, die sich in der Antriebseinheit bilden, an den Wafer 1 gelangen.

## Patentansprüche

1. Vorrichtung zum Behandeln mindestens einer Unterseite (1u) eines scheibenförmigen Gegenstandes (1), mit folgenden Merkmalen:
1.1 Einem rotierbaren Träger (2) mit einer oberen Stimfläche (2o), von der, zur Positionierung des scheibenförmigen Gegenstandes (1), parallel zur oberen Stirnfläche (2o) des Trägers (2), mindestens zwei Einrichtungen (19) abstehen,
1.2 mindestens einer, ortsfest angeordneten, mittig den Träger (2) durchgreifenden Leitung (20), (22), (24), (26) zur Zuführung eines Behandlungsmediums gegen die Unterseite (1u) des scheibenförmigen Gegenstandes (1),
1.3 einer, unter Ausbildung eines Ringspalts (16) im Abstand zu mindestens einem Abschnitt einer unteren Stirnfläche (2u) des Trägers (2) ortsfest angeordneten Abdeckung (4), die von der mindestens einen Leitung (20), (22), (24), (26) spielfrei durchgriffen wird.

2. Vorrichtung nach Anspruch 1, bei der die Abdeckung (4), benachbart zu der mindestens einen Leitung (20), (22), (24), (26) einen parallel zur oberen Stirnfläche (2o) des Trägers (2) verlaufenden inneren Teil (4i) und einen randseitigen, relativ zur oberen Stirnfläche (2o) des Trägers (2) abfallenden äußeren Teil (4a) aufweist.

3. Vorrichtung nach Anspruch 1, bei der die untere Stimfläche (2u) des Trägers (2) korrespondierend zur Abdeckung (4) gestaltet ist.

4. Vorrichtung nach Anspruch 1, bei der der Träger (2) die Abdeckung (4), radial zur Leitung (20), (22), (24), (26), überragt .

5. Vorrichtung nach Anspruch 1, bei der die Abdeckung (4) auf einem, die mindestens eine Leitung (20),(22),(24),(26) aufnehmenden rohrförmigen Körper (8) ortsfest aufsitzt.

6. Vorrichtung nach Anspruch 1, bei der sich an die untere Stirnfläche (2u) des Trägers (2) eine, die mindestens eine Leitung (20), (22), (24), (26) mit Abstand umgreifende Ringscheibe (7) anschließt, die außenseitig mit dem Träger (2) verbunden ist und im übrigen im Abstand (16u) zur Abdeckung (4) verläuft.

7. Vorrichtung nach Anspruch 6, bei der zwischen Träger (2) und Ringscheibe (7), in Verlängerung des Ringspalts (16) mindestens ein im Wesentlichen radial zur Leitung (20), (22), (24), (26) verlaufender Spalt (16s) angeordnet ist.

8. Vorrichtung nach Anspruch 6, bei der die Ringscheibe (7) innenseitig auf einem Drehlager (D1) geführt ist, welches sich gegen einen, die Abdeckung (4) tragenden rohrförmigen Körper (8) abstützt.

9. Vorrichtung nach Anspruch 6, bei der die Ringscheibe (7) mit einer rohrförmigen Verlängerung (5) ausgebildet ist, die parallel zu der mindestens einen Leitung (20), (22), (24), (26) in Richtung von der unteren Stirnfläche (2u) des Trägers (2) weg verläuft.

10. Vorrichtung nach Anspruch 9, bei der die rohrförmige Verlängerung (5) die mindestens eine Leitung (20), (22), (24), (26) und einen die mindestens eine Leitung (20), (22), (24), (26) aufnehmenden rohrförmigen Körper (8) mit Abstand umgreift.

11. Vorrichtung nach Anspruch 9, bei der die rohrförmige Verlängerung (5) an einen Rotations-Antrieb (3) gekuppelt ist.

12. Vorrichtung nach Anspruch 11, bei der der Rotations-Antrieb (3) aus einem Motor besteht, dessen Rotor (3r) mit der rohrförmigen Verlängerung (5) verbunden ist und dessen Stator (3s) über mindestens ein Drehlager (D2),(D3) gegen die rohrförmige Verlängerung (5) anliegt.

## Claims

1. Device for treating at least an underside (1u) of a disc-like object (1), having the following features:
1.1 a rotatable support (2) with an upper end face (2o) from which, in order to position the disc-like object (1), at least two mechanisms (19) project parallel to the upper end face (2o) of the support (2),
1.2 at least one pipe (20), (22), (24), (26) which is disposed in a stationary manner and penetrates centrally through the support (2) for supplying a treatment medium against the underside (1u) of the disc-like object (1),
1.3 a cover (4) which, by forming an annular gap (16), is disposed in a stationary manner at a spacing relative to at least one portion of a lower end face (2u) of the support (2), said cover being penetrated by at least one pipe (20), (22), (24), (26) without clearance.

2. Device according to claim 1, in which the cover (4), adjacent to the at least one pipe (20), (22), (24), (26) has an inner part (4i) which extends parallel to the upper end face(2o) of the support (2) and an outer part (4a) which drops at the edge side relative to the upper end face (2o) of the support (2).

3. Device according to claim 1, in which the lower end face (2u) of the support (2) is configured correspondingly to the cover (4).

4. Device according to claim 1, in which the support (2) projects beyond the cover (4) radially relative to the pipe (20), (22), (24), (26).

5. Device according to claim 1, in which the cover (4) sits in a stationary manner on a tubular body (8) which receives at least one pipe (20), (22), (24), (26).

6. Device according to claim 1, in which an annular disc (7) is connected to the lower end face (2u) of the support (2), which annular disc engages around the at least one pipe (20), (22), (24), (26) with a spacing, is connected at the outside to the support (2) and extends furthermore at a spacing (16u) relative to the cover (4).

7. Device according to claim 6, in which at least one gap (16s) which extends essentially radially relative to the pipe (20), (22), (24), (26) is disposed between the support (2) and the annular disc (7), as an extension of the annular gap (16).

8. Device according to claim 6, in which the annular disc (7) is guided on a pivot bearing (D1) on the inside, said pivot bearing being supported against a tubular body (8) which supports the cover (4).

9. Device according to claim 6, in which the annular disc (7) is configured with a tubular extension (5), which extends parallel to the at least one pipe (20), (22), (24), (26) in the direction away from the lower end face (2u) of the support (2).

10. Device according to claim 9, in which the tubular extension (5) engages with a spacing around the at least one pipe (20), (22), (24), (26) and around a tubular body (8) which receives the at least one pipe (20), (22), (24), (26).

11. Device according to claim 9, in which the tubular extension (5) is coupled to a rotational drive (3).

12. Device according to claim 11, in which the rotational drive (3) comprises a motor, the rotor (3r) of which is connected to the tubular extension (5) and the stator (3s) of which abuts against the tubular extension (5) via at least one pivot bearing (D2), (D3).

## Revendications

1. Dispositif de traitement d'au moins une face inférieure (1u) d'un objet (1) en forme de disque, présentant les caractéristiques suivantes:
1.1 un support (2) rotatif avec une face frontale supérieure (2o) sur laquelle font saillie au moins deux organes (19), parallèlement à la face frontale supérieure (2o) du support (2), en vue du positionnement de l'objet (1) en forme de disque,
1.2 au moins une conduite (20), (22), (24), (26) fixe qui traverse le support (2) en son centre et sert à amener un fluide de traitement contre la face inférieure (1u) de l'objet (1) en forme de disque,
1.3 un élément de recouvrement (4) fixe qui est disposé à distance d'au moins une partie de la face frontale inférieure (2u) du support (2), avec formation d'un espace annulaire (16), et est traversé sans jeu par la conduite (20), (22), (24), (26), au nombre d'au moins une.

2. Dispositif selon la revendication 1, dans lequel l'élément de recouvrement (4), dans le voisinage de la conduite (20), (22), (24), (26), au nombre d'au moins une, présente une partie intérieure (4i), parallèle à la face frontale supérieure (2o) du support (2), et une partie de bord extérieure (4a) qui est inclinée vers le bas par rapport à la face frontale supérieure (2o) du support (2).

3. Dispositif selon la revendication 1, dans lequel la face frontale inférieure (2u) du support (2) a une conformation correspondant à celle de l'élément de recouvrement (4).

4. Dispositif selon la revendication 1, dans lequel le support (2) dépasse par rapport à l'élément de recouvrement (4), radialement par rapport à la conduite (20), (22), (24), (26).

5. Dispositif selon la revendication 1, dans lequel l'élément de recouvrement (4) est monté stationnaire sur un corps (8) tubulaire recevant la conduite (20), (22), (24), (26), au nombre d'au moins une.

6. Dispositif selon la revendication 1, dans lequel il est prévu, à la suite de la face frontale inférieure (2u) du support (2), une plaque annulaire (7) qui entoure à distance la conduite (20), (22), (24), (26), au nombre d'au moins une, est reliée côté extérieur au support (2) et présente par ailleurs la distance (16u) par rapport à l'élément de recouvrement (4).

7. Dispositif selon la revendication 6, dans lequel il est prévu, entre le support (2) et la plaque annulaire (7) et dans le prolongement de l'espace annulaire (16), au moins un espace (16s) qui s'étend de façon sensiblement radiale par rapport à la conduite (20), (22), (24), (26).

8. Dispositif selon la revendication 6, dans lequel la plaque annulaire (7) est montée, côté intérieur, sur un palier tournant (D1) qui est en appui sur un corps (8) tubulaire portant l'élément de recouvrement (4).

9. Dispositif selon la revendication 6, dans lequel la plaque annulaire (7) est réalisée avec un prolongement (5) tubulaire qui s'étend parallèlement à la conduite (20), (22), (24), (26), au nombre d'au moins une, en s'éloignant de la face frontale inférieure (2u) du support (2).

10. Dispositif selon la revendication 9, dans lequel le prolongement (5) tubulaire entoure à distance la conduite (20), (22), (24), (26), au nombre d'au moins une, ainsi qu'un corps (8) tubulaire recevant la conduite (20), (22), (24), (26), au nombre d'au moins une.

11. Dispositif selon la revendication 9, dans lequel le prolongement (5) tubulaire est couplé à un moyen d'entraînement en rotation (3).

12. Dispositif selon la revendication 11, dans lequel le moyen d'entraînement en rotation (3) est constitué d'un moteur dont le rotor (3r) est lié au prolongement (5) tubulaire et dont le stator (3s) est en appui sur le prolongement (5) tubulaire, par l'intermédiaire d'au moins un palier tournant (D2), (D3).
